# EUROPÄISCHE PATENTSCHRIFT

(11) **EP 0 871 230 B1**
(45) Veröffentlichungstag und Bekanntmachung des Hinweises auf die Patenterteilung: **22.09.2004**
(21) Anmeldenummer: 97121557.9
(22) Anmeldetag: 08.12.1997
(51) Int. Cl.: H01L 41/04

(54) **Verfahren und Vorrichtung zum Laden und Entladen eines piezoelektrischen Elements**
Method and apparatus for charging and discharging a piezoelectric element
Procédé et appareil pour charger et décharger un élément piézoélectrique

(30) Priorität: 09.04.1997 DE 19714616
(43) Veröffentlichungstag der Anmeldung: 14.10.1998
(73) Patentinhaber: ROBERT BOSCH GMBH, 70442 Stuttgart (DE)
(72) Erfinder: Reineke, Jörg, 70469 Stuttgart (DE); Hock, Alexander, 70435 Stuttgart (DE)

(56) Entgegenhaltungen:
- EP-A- 0 464 443
- DE-A- 4 435 832
- PATENT ABSTRACTS OF JAPAN vol. 016, no. 282 (M-1269), 23.Juni 1992 & JP 04 071859 A (BROTHER IND LTD), 6.März 1992,

## Beschreibung

Die vorliegende Erfindung betrifft ein Verfahren gemäß dem Oberbegriff des Patentanspruchs 1 und eine Vorrichtung gemäß dem Oberbegriff des Patentanspruchs 9, d.h. ein Verfahren und eine Vorrichtung zum Laden und Entladen eines piezoelektrischen Elements, wobei sowohl das Laden als auch das Entladen zumindest teilweise über ein für den Lade- bzw. den Entladestrom im wesentlichen als eine Induktanz wirkendes Element erfolgt.

Aus dem Patent Abstract of Japan, Vol. 016, no. 282 (M-1269), 23. Juni 1992 & JP 04 071859 ist eine Schaltungsanordnung zum Laden und Entladen einer kapazitiven Last bekannt. Dabei wird die kapazitive Last mit Beginn des Ladevorganges über ein Schaltmittel mit einer Spannungsquelle verbunden. Nach Ablauf der bestimmten Zeit wird der Schalter geöffnet und der Ladevorgang beendet. Der Schalter wird mit Beginn des Ladevorgangs leitend geschaltet und nach einer bestimmten Zeit wieder geöffnet. Mit einer solchen Ansteuerung ist lediglich eine ungenaue Zumessung möglich, die allenfalls bei der Verwendung bei einem Tintenstrahldrucker ausreichend ist.

Auch die DE 44 35 832 A zeigt eine Schaltungsanordnung Laden und Entladen kapazitiver Lasten. Bei dieser Vorrichtung ist die Induktanz parallel zu dem Piezoaktor geschaltet.

Bei den vorliegend näher betrachteten piezoelektrischen Elementen handelt es sich insbesondere, aber nicht ausschließlich um als Aktoren bzw. Stellglieder verwendete piezoelektrische Elemente. Piezoelektrische Elemente lassen sich für derartige Zwecke einsetzen, weil sie bekanntermaßen die Eigenschaft aufweisen, sich in Abhängigkeit von einer daran angelegten Spannung zusammenzuziehen oder auszudehnen.

Die praktische Realisierung von Stellgliedern durch piezoelektrische Elemente erweist sich insbesondere dann von Vorteil, wenn das betreffende Stellglied schnelle und/oder häufige Bewegungen auszuführen hat.

Der Einsatz von piezoelektrischen Elementen als Stellglied erweist sich unter anderem bei Kraftstoff-Einspritzdüsen für Brennkraftmaschinen als vorteilhaft. Zur Einsetzbarkeit von piezoelektrischen Elementen in Kraftstoff-Einspritzdüsen wird beispielsweise auf die EP 0 371 469 B1 und die EP 0 379 182 B1 verwiesen.

Piezoelektrische Elemente sind kapazitive Verbraucher, welche sich, wie vorstehend teilweise bereits angedeutet wurde, entsprechend dem jeweiligen Ladungszustand bzw. der sich daran einstellenden oder angelegten Spannung zusammenziehen und ausdehnen.

Zum Laden und Entladen eines piezoelektrischen Elements sind zwei grundlegende Prinzipien bekannt, nämlich das Laden und Entladen über einen ohmschen Widerstand und das Laden und Entladen über eine Spule, wobei sowohl der ohmsche Widerstand als auch die Spule unter anderem dazu dienen, den beim Laden auftretenden Ladestrom und den beim Entladen auftretenden Entladestrom zu begrenzen.

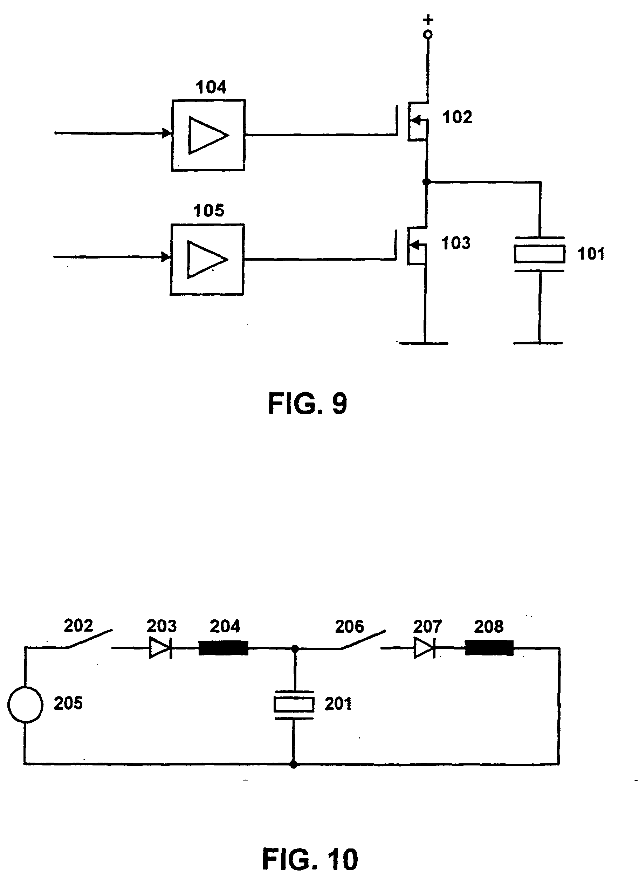

Die erste Variante, d.h. das Laden und Entladen über einen ohmschen Widerstand ist in Figur 9 veranschaulicht.

Das zu ladende bzw. zu entladende piezoelektrische Element, welches in der Figur 9 mit dem Bezugszeichen 101 bezeichnet ist, ist mit einem Ladetransistor 102 und einem Entladetransistor 103 verbunden.

Der Ladetransistor 102 wird durch einen Ladeverstärker 104 angesteuert und verbindet im durchgeschalteten Zustand das piezoelektrische Element 101 mit einer positiven Versorgungsspannung; der Entladetransistor 103 wird durch einen Entladeverstärker 105 angesteuert und verbindet im durchgeschalteten Zustand das piezoelektrische Element 101 mit Masse.

Im durchgeschalteten Zustand des Ladetransistors 102 fließt über diesen ein Ladestrom, durch welchen das piezoelektrische Element 101 geladen wird. Mit zunehmender Ladung des piezoelektrischen Elements 101 steigt die sich an diesem einstellende Spannung, und dementsprechend verändern sich auch dessen äußere Abmessungen. Ein Sperren des Ladetransistors 102, also ein Unterbrechen oder Beenden des Ladevorganges bewirkt, daß die im piezoelektrischen Element 101 gespeicherte Ladung bzw. die sich an diesem dadurch einstellende Spannung und damit auch die aktuellen äußeren Abmessungen des piezoelektrischen Elements 101 im wesentlichen unverändert beibehalten werden.

Im durchgeschalteten Zustand des Entladetransistors 103 fließt über diesen ein Entladestrom, durch welchen das piezoelektrische Element 101 entladen wird. Mit zunehmender Entladung des piezoelektrischen Elements 101 sinkt die sich an diesem einstellende Spannung, und dementsprechend verändern sich auch dessen äußere Abmessungen. Ein Sperren des Entladetransistors 103, also ein Unterbrechen oder Beenden des Entladevorganges bewirkt, daß die im piezoelektrischen Element 101 noch gespeicherte Ladung bzw. die sich an diesem dadurch einstellende Spannung und damit auch die aktuellen äußeren Abmessungen des piezoelektrischen Elements 101 beibehalten werden.

Der Ladetransistor 102 und der Entladetransistor 103 wirken für den Ladestrom bzw. für den Entladestrom wie steuerbare ohmsche Widerstände. Die dadurch gegebene Steuerbarkeit des Ladestroms und des Entladestroms ermöglicht es, den Ladevorgang und den Entladevorgang genau wunschgemäß ablaufen zu lassen. Der durch den Ladetransistor 102 fließende Ladestrom und der durch den Entladetransistor 103 fließende Entladestrom erzeugen dort jedoch nicht unerhebliche Verlustleistungen. Die in den Transistoren verbrauchte Verlustenergie ist pro Lade-Entladezyklus mindestens doppelt so hoch wie die im piezoelektrischen Element 101 gespeicherte Energie. Diese hohe Verlustenergie bewirkt eine sehr starke Aufheizung des Ladetransistors 102 und des Entladetransistors 103, was erkennbar ein Nachteil ist.

Nicht zuletzt deshalb kommt häufig die vorstehend bereits erwähnte zweite Variante zum Laden und Entladen des piezoelektrischen Elements, d.h. das Laden und Entladen über eine Spule zum Einsatz; eine praktische Realisierung dieser zweiten Variante ist in Figur 10 veranschaulicht.

Das zu ladende bzw. zu entladende piezoelektrische Element, welches in der Figur 10 mit dem Bezugszeichen 201 bezeichnet ist, ist Bestandteil eines über einen Ladeschalter 202 schließbaren Ladestromkreises und eines über einen Entladeschalter 206 schließbaren Entladestromkreises, wobei der Ladestromkreis aus einer Serienschaltung des Ladeschalters 202, einer Diode 203, einer Ladespule 204, des piezoelektrischen Elements 201, und einer Spannungsquelle 205 besteht, und wobei der Entladestromkreis aus einer Serienschaltung des Entladeschalters 206, einer Diode 207, einer Entladespule 208 und des piezoelektrischen Elements 201 besteht.

Die Diode 203 des Ladestromkreises verhindert, daß im Ladestromkreis ein das piezoelektrische Element entladender Strom fließen kann. Die Diode 203 und der Ladeschalter 202 sind gemeinsam als ein Halbleiterschalter realisierbar.

Die Diode 207 des Entladestromkreises verhindert, daß im Entladestromkreis ein das piezoelektrische Element ladender Strom fließen kann. Die Diode 207 und der Ladeschalter 206 sind wie die Diode 203 und der Ladeschalter 202 gemeinsam als ein Halbleiterschalter realisierbar.

Wird der normalerweise geöffnete Ladeschalter 202 geschlossen, so fließt im Ladestromkreis ein Ladestrom, durch welchen das piezoelektrische Element 201 geladen wird; die im piezoelektrischen Element 201 gespeicherte Ladung bzw. die sich an diesem dadurch einstellende Spannung und damit auch die aktuellen äußeren Abmessungen des piezoelektrischen Elements 201 werden nach dem Laden desselben im wesentlichen unverändert beibehalten.

Wird der normalerweise ebenfalls geöffnete Entladeschalter 206 geschlossen, so fließt im Entladestromkreis ein Entladestrom, durch welchen das piezoelektrische Element 201 entladen wird; der Ladezustand des piezoelektrischen Elements 201 bzw. die sich an diesem dadurch einstellende Spannung und damit auch die aktuellen äußeren Abmessungen des piezoelektrischen Elements 201 werden nach dem Entladen desselben im wesentlichen unverändert beibehalten.

Die Ladespule 204 und die Entladespule 206 stellen für den Ladestrom bzw. den Entladestrom im wesentlichen ein als eine Induktanz wirkendes Element dar; die Ladespule 204 und das piezoelektrische Element 201 sowie die Entladespule 206 und das piezoelektrische Element 201 bilden beim Laden bzw. Entladen des piezoelektrischen Elements jeweils einen LC-Reihenschwingkreis.

Schaltungen der unter Bezugnahme auf die Figur 10 beschriebenen Art und Verfahren zum Laden und Entladen piezoelektrischer Elemente unter Verwendung derartiger Schaltungen sind aus den eingangs bereits erwähnten Druckschriften EP 0 371 469 B1 und EP 0 379 182 B1 bekannt.

Die aus den genannten Druckschriften bekannten und vorstehend dem grundlegenden Prinzip nach beschriebenen Verfahren und Vorrichtungen sind Verfahren gemäß dem Oberbegriff des Patentanspruchs 1 bzw. Vorrichtungen gemäß dem Oberbegriff des Patentanspruchs 9.

Da bei Schaltungen gemäß der Figur 10 sowohl der Ladestromkreis als auch der Entladestromkreis frei von nennenswerten ohmschen Widerständen sind, ist die durch das Laden und Entladen des piezoelektrischen Elements (die durch das Fließen des Ladestroms und des Entladestroms durch ohmsche Widerstände) erzeugte Wärmeenergie äußerst gering.

Andererseits wird aber für die praktische Realisierung derartiger Schaltungen insbesondere wegen der nicht unerheblichen Größe der Ladespule 204 und der Entladespule 208 relativ viel Platz benötigt, wodurch das Laden und das Entladen von piezoelektrischen Elementen über ein für den Lade- bzw. den Entladestrom im wesentlichen als eine Induktanz wirkendes Element in bestimmten Fällen nicht oder jedenfalls nicht ohne weiteres möglich ist.

Der vorliegenden Erfindung liegt daher die Aufgabe zugrunde, das Verfahren gemäß dem Oberbegriff des Patentanspruchs 1 bzw. die Vorrichtung gemäß dem Oberbegriff des Patentanspruchs 9 derart weiterzubilden, daß damit auch unter beengten Verhältnissen ein effizientes Laden und Entladen piezoelektrischer Elemente ermöglicht wird.

Diese Aufgabe wird erfindungsgemäß durch die im kennzeichnenden Teil des Patentanspruchs 1 (Verfahren) bzw. durch die im kennzeichnenden Teil des Patentanspruchs 9 (Vorrichtung) beanspruchten Merkmale gelöst.

Demnach ist vorgesehen, daß der Ladestrom und der Entladestrom zumindest teilweise über das selbe als Induktanz wirkende Element geleitet werden (kennzeichnender Teil des Patentanspruchs 1) bzw. daß zumindest ein als Induktanz wirkendes Element derart angeordnet ist, daß sowohl der Ladestrom als auch der Entladestrom über dieses geleitet werden können (kennzeichnender Teil des Patentanspruchs 9.

Das zumindest teilweise Laden bzw. Entladen des piezoelektrischen Elements über ein für den Lade- oder Entladestrom im wesentlichen als eine Induktanz wirkendes Element, also beispielsweise über eine Spule oder ein wie eine Spule wirkendes Element ermöglicht es, den Ladestrompfad und den Entladestrompfad im wesentlichen frei von elektrischen Verbrauchern zu halten, wodurch einerseits sehr wenig Energie verbraucht wird (weil die Verlustleistung gering ist und weil die beim Entladen aus dem piezoelektrischen Element abgezogene Energie zur Spannungsquelle zurückgeführt oder in einen Kondensator umgespeichert werden kann), und wodurch andererseits die beim Laden bzw. Entladen auftretende Erwärmung der Schaltung äußerst gering gehalten werden kann. Im Ergebnis können dadurch die einzelnen Bauteile (einschließlich der Stromversorgung) für relativ geringe Leistungen ausgelegt werden, und die bislang mitunter erforderlichen Maßnahmen zur Kühlung können entweder gänzlich entfallen oder jedenfalls in ihrem Umfang sehr gering gehalten werden.

Das Leiten des Ladestroms und des Entladestroms über das selbe als Induktanz wirkende Element, d.h. das Leiten des Ladestroms und des Entladestroms beispielsweise über die selbe Spule oder über ein wie eine Spule wirkendes Element ermöglicht es darüber hinaus, die Anzahl der Bauteile, genauer gesagt die Anzahl der als Induktanz wirkenden Elemente minimal zu halten, was sich aufgrund der nicht unerheblichen Größe dieser Elemente erkennbar sehr deutlich auf die Größe der betrachteten Anordnung auswirkt.

Damit ist es auf einfache und elegante Art und Weise möglich, auch unter beengten Verhältnissen ein effizientes Laden und Entladen piezoelektrischer Elemente durchzuführen.

Die erfindungsgemäße Vorrichtung ist darüber hinaus auch einfacher und billiger herstellbar als dies bei herkömmlichen Vorrichtungen der Fall ist.

Vorteilhafte Weiterbildungen der Erfindung sind Gegenstand der Unteransprüche.

Die Erfindung wird nachfolgend anhand von Ausführungsbeispielen unter Bezugnahme auf die Zeichnung näher erläutert. Es zeigen
- Figur 1: eine zum Laden und Entladen eines piezoelektrischen Elements nach dem erfindungsgemäßen Verfahren geeignete erfindungsgemäße Schaltung,
- Figur 2: eine Darstellung zur Erläuterung der sich während einer ersten Ladephase (Ladeschalter 3 geschlossen) in der Schaltung nach Figur 1 einstellenden Verhältnisse,
- Figur 3: eine Darstellung zur Erläuterung der sich während einer zweiten Ladephase (Ladeschalter 3 wieder geöffnet) in der Schaltung nach Figur 1 einstellenden Verhältnisse,
- Figur 4: eine Darstellung zur Erläuterung der sich während einer ersten Entladephase (Entladeschalter 5 geschlossen) in der Schaltung nach Figur 1 einstellenden Verhältnisse,
- Figur 5: eine Darstellung zur Erläuterung der sich während einer zweiten Entladephase (Entladeschalter 5 wieder geöffnet) in der Schaltung nach Figur 1 einstellenden Verhältnisse,
- Figur 6: den zeitlichen Verlauf von sich beim Betrieb der Schaltung gemäß Figur 1 einstellenden Spannungs- und Stromverläufen,
- Figur 7: eine zum sequentiellen Laden und Entladen mehrerer piezoelektrischer Elemente nach dem erfindungsgemäßen Verfahren geeignete erfindungsgemäße Schaltung,
- Figur 8: den zeitlichen Verlauf von sich beim Betrieb der Schaltung gemäß Figur 7 einstellenden Spannungs- und Stromverläufen,
- Figur 9: eine herkömmliche Schaltung zum Laden und Entladen eines piezoelektrischen Elements über für den Lade- und Entladestrom als ohmsche Widerstände wirkende Elemente, und
- Figur 10: eine herkömmliche Schaltung zum Laden und Entladen eines piezoelektrischen Elements über für den Lade- und Entladestrom als Spulen wirkende Elemente.

Die piezoelektrischen Elemente, deren Laden und Entladen im folgenden näher beschrieben wird, sind beispielsweise als Stellglieder in Kraftstoff-Einspritzdüsen (insbesondere in sogenannten Common Rail Injektoren) von Brennkraftmaschinen einsetzbar. Auf einen derartigen Einsatz der piezoelektrischen Elemente besteht jedoch keinerlei Einschränkung; die piezoelektrischen Elemente können grundsätzlich in beliebigen Vorrichtungen für beliebige Zwecke eingesetzt werden.

Es wird davon ausgegangen, daß sich die piezoelektrischen Elemente im Ansprechen auf das Laden ausdehnen und im Ansprechen auf das Entladen zusammenziehen. Die Erfindung ist selbstverständlich jedoch auch dann anwendbar, wenn dies gerade umgekehrt ist.

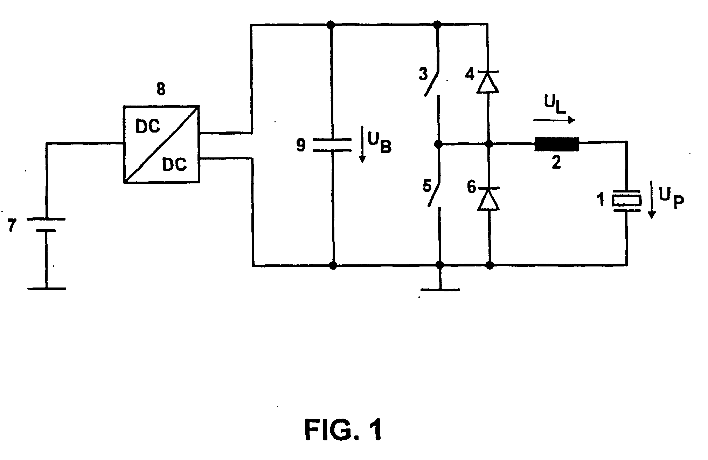

Es wird nun unter Bezugnahme auf Figur 1 ein erstes Ausführungsbeispiel einer Schaltung zur Durchführung des erfindungsgemäßen Verfahrens zum Laden und Entladen eines piezoelektrischen Elements beschrieben.

Das piezoelektrische Element, das es im betrachteten Beispiel zu laden gilt, ist in der Figur 1 mit dem Bezugszeichen 1 bezeichnet.

Wie aus der Figur 1 ersichtlich ist, liegt der eine der Anschlüsse des piezoelektrischen Elements 1 dauerhaft auf Masse (ist mit einem ersten Pol einer Spannungsquelle verbunden), wohingegegen der andere der Anschlüsse des piezoelektrischen Elements über eine Spule 2 und eine Parallelschaltung aus einem Ladeschalter 3 und einer Diode 4 mit dem zweiten Pol der Spannungsquelle und über die Spule 2 und eine Parallelschaltung aus einem Entladeschalter 5 und einer Diode 6 mit dem ersten Pol der Spannungsquelle verbunden ist.

Die Spannungsquelle besteht aus einer Batterie 7 (beispielsweise einer KFZ-Batterie), einem dieser nachgeschalteten Gleichspannungswandler 8, und einem diesem nachgeschalteten, als Pufferkondensator dienenden Kondensator 9. Durch diese Anordnung wird die Batteriespannung (beispielsweise 12 V) in eine im wesentlichen beliebige andere Gleichspannung umgesetzt und als Versorgungsspannung bereitgestellt.

Das Laden und das Entladen des piezoelektrischen Elements 1 erfolgen im betrachteten Beispiel getaktet. D.h., der Ladeschalter 3 und der Entladeschalter 5 werden während des Lade- bzw. Entladevorganges wiederholt geschlossen und geöffnet.

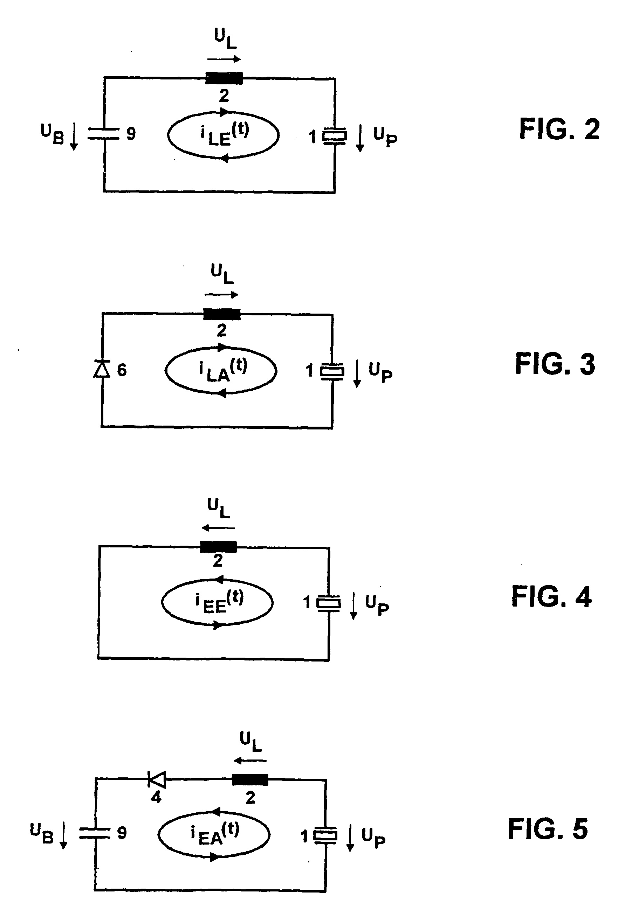

Die sich dabei einstellenden Verhältnisse werden nachfolgend unter Bezugnahme auf die Figuren 2 bis 5 erläutert, von denen die Figuren 2 und 3 das Laden des piezoelektrischen Elements 1, und die Figuren 4 und 5 das Entladen des piezoelektrischen Elements 1 veranschaulichen.

Der Ladeschalter 3 und der Entladeschalter 5 sind, wenn und solange kein Laden oder Entladen des piezoelektrischen Elements 1 erfolgt, geöffnet. In diesem Zustand befindet sich die in der Figur 1 gezeigte Schaltung im stationären Zustand. D.h., das piezoelektrische Element 1 behält seinen Ladungszustand im wesentlichen unverändert bei, und es fließen keine Ströme.

Mit dem Beginn des Ladens des piezoelektrischen Elements 1 wird der Ladeschalter 3 wiederholt geschlossen und geöffnet; der Entladeschalter 5 bleibt hierbei geöffnet.

Beim Schließen des Ladeschalters 3 stellen sich die in der Figur 2 gezeigten Verhältnisse ein. D.h., es wird ein aus einer Reihenschaltung aus dem piezoelektrischen Element 1, dem Kondensator 9 und der Spule 2 bestehender geschlossener Stromkreis gebildet, in welchem ein wie in der Figur 2 durch Pfeile angedeuteter Strom i_{LE}(t) fließt. Dieser Stromfluß bewirkt, daß in der Spule 2 Energie gespeichert wird. Der Energiefluß in die Spule 2 wird dabei durch die positive Potentialdifferenz zwischen dem Kondensator 9 und dem piezoelektrischen Element 1 bewirkt.

Beim kurz (beispielsweise einige µs) nach dem Schließen des Ladeschalters 3 erfolgenden Öffnen desselben stellen sich die in der Figur 3 gezeigten Verhältnisse ein. D.h., es wird ein aus einer Reihenschaltung aus dem piezoelektrischen Element 1, der Diode 6 und der Spule 2 bestehender geschlossener Stromkreis gebildet, in welchem ein wie in der Figur 3 durch Pfeile angedeuteter Strom i_{LA}(t) fließt. Dieser Stromfluß bewirkt, daß in der Spule 2 gespeicherte Energie vollständig in das piezoelektrische Element 1 fließt. Entsprechend der Energiezufuhr zum piezoelektrischen Element erhöhen sich die an diesem einstellende Spannung und dessen äußere Abmessungen. Nach erfolgtem Energietransport von der Spule 2 zum piezoelektrischen Element 1 ist wieder der vorstehend bereits erwähnte stationäre Zustand der Schaltung nach Figur 1 erreicht.

Dann oder auch schon vorher oder auch erst später (je nach dem gewünschten zeitlichen Verlauf des Ladevorgangs) wird der Ladeschalter 3 erneut geschlossen und wieder geöffnet, wobei sich die vorstehend beschriebenen Vorgänge wiederholen. Durch das erneute Schließen und Öffnen des Ladeschalters 3 nimmt die im piezoelektrischen Element 1 gespeicherte Energie zu (die im piezoelektrischen Element bereits gespeicherte Energie und die neu zugeführte Energie summieren sich), und dementsprechend nehmen die sich am piezoelektrischen Element einstellende Spannung und dessen äußere Abmessungen zu.

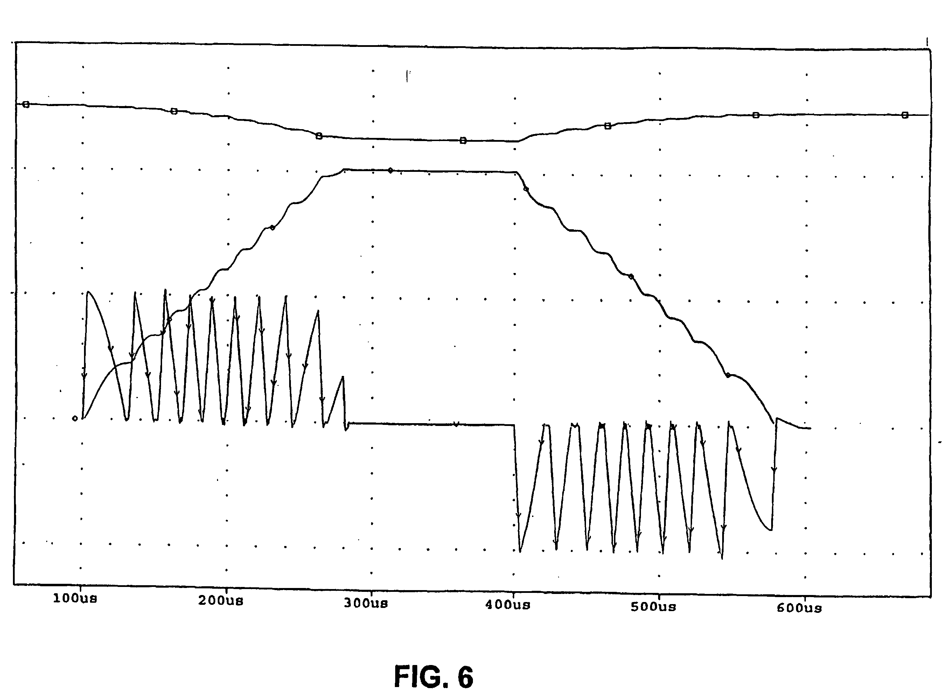

Wiederholt man das beschriebene Schließen und Öffnen des Ladeschalters 3 eine Vielzahl von Malen, so steigen die sich am piezoelektrischen Element einstellende Spannung und die Ausdehnung des piezoelektrischen Elements stufenweise an (siehe hierzu die erst später erläuterte Darstellung in der Figur 6).

Wurde der Ladeschalter 3 eine vorbestimmte Anzahl von Malen geschlossen und geöffnet und/oder hat das piezoelektrische Element 1 den gewünschten Ladezustand erreicht, so wird das Laden des piezoelektrischen Elements durch Offenlassen des Ladeschalters 3 beendet.

Soll das piezoelektrische Element 1 wieder entladen werden, so wird dies durch ein wiederholtes Schließen und Öffnen des Entladeschalters 5 bewerkstelligt; der Ladeschalter 3 bleibt hierbei geöffnet.

Beim Schließen des Entladeschalters 5 stellen sich die in der Figur 4 gezeigten Verhältnisse ein. D.h., es wird ein aus einer Reihenschaltung aus dem piezoelektrischen Element 1 und der Spule 2 bestehender geschlossener Stromkreis gebildet, in welchem ein wie in der Figur durch Pfeile angedeuteter Strom i_{EE}(t) fließt. Dieser Stromfluß bewirkt, daß die im piezoelektrischen Element gespeicherte Energie (ein Teil derselben) in die Spule 2 transportiert wird. Entsprechend dem Energietransfer vom piezoelektrischen Element 1 zur Spule 2 nehmen die sich am piezoelektrischen Element einstellende Spannung und dessen äußere Abmessungen ab.

Beim kurz (beispielsweise einige µs) nach dem Schließen des Entladeschalters 5 erfolgenden Öffnen desselben stellen sich die in der Figur 5 gezeigten Verhältnisse ein. D.h., es wird ein aus einer Reihenschaltung aus dem piezoelektrischen Element 1, dem Kondensator 9, der Diode 4 und der Spule 2 bestehender geschlossener Stromkreis gebildet, in welchem ein wie in der Figur durch Pfeile angedeuteter Strom i_{EA}(t) fließt. Dieser Stromfluß bewirkt, daß in der Spule 2 gespeicherte Energie vollständig in den Kondensator 9 zurückgespeist wird. Nach erfolgtem Energietransport von der Spule 2 zum Kondensator 9 ist wieder der vorstehend bereits erwähnte stationäre Zustand der Schaltung nach Figur 1 erreicht.

Dann oder auch schon vorher oder erst später (je nach dem gewünschten zeitlichen Verlauf des Entladevorgangs wird der Entladeschalter 5 erneut geschlossen und wieder geöffnet, wobei sich die vorstehend beschriebenen Vorgänge wiederholen. Durch das erneute Schließen und Öffnen des Entladeschalters 5 nimmt die im piezoelektrischen Element 1 gespeicherte Energie weiter ab, und dementsprechend nehmen die sich am piezoelektrischen Element einstellende Spannung und dessen äußere Abmessungen ebenfalls ab.

Wiederholt man das beschriebene Schließen und Öffnen des Entladeschalters 5 eine Vielzahl von Malen, so nehmen die sich am piezoelektrischen Element einstellende Spannung und die Ausdehnung des piezoelektrischen Elements stufenweise ab (siehe hierzu die Darstellung in der Figur 6).

Wurde der Entladeschalter 3 eine vorbestimmte Anzahl von Malen geschlossen und geöffnet und/oder hat das piezoelektrische Element den gewünschten Entladezustand erreicht, so wird das Entladen des piezoelektrischen Elements durch Offenlassen des Entladeschalters 5 beendet.

Betreibt man die in der Figur 1 gezeigte Schaltung, genauer gesagt das Laden und Entladen des piezoelektrischen Elements 1 wie vorstehend beschrieben, so stellen sich die in der Figur 6 gezeigten Strom- und Spannungsverläufe ein.

Die in der Figur 6 dargestellten Kurven sind mit deren Meßgrößen repräsentierenden Symbolen versehen. Von den verwendeten Symbolen repräsentieren
- □: die sich am Kondensator 9 einstellende Spannung U_{B},
- ◇: die sich am piezoelektrischen Element 1 einstellende Spannung, und
- ∨: den die Spule 2 durchfließenden Strom

Die in der Figur 6 gezeigten Strom- und Spannungsverläufe veranschaulichen den Ladevorgang (im Bereich von etwa 100 µs bis 300 µs auf der Zeitskala) und den Entladevorgang (im Bereich von etwa 400 µs bis 600 µs auf der Zeitskala); sie sind bei der vorstehend vermittelten Kenntnis des Aufbaus, der Funktion und der Wirkungsweise der Schaltung gemäß der Figur 1 ohne weiteres verständlich und bedürfen keiner näheren Erläuterung.

Wie aus der Figur 6 ersichtlich ist, weist die sich am piezoelektrischen Element 1 einstellende Spannung einen homogenen und erkennbar gut steuerbaren Verlauf auf.

Gleichzeitig ist die Schaltung, durch die das Laden und Entladen des piezoelektrischen Elements bewirkt wird, genauer gesagt die Schaltung gemäß Figur 1 denkbar einfach aufgebaut und optimal im Wirkungsgrad. Hierzu tragen insbesondere drei Faktoren bei, nämlich
1) daß das Laden und das Entladen über ein und die selbe Spule (nämlich die Spule 2) erfolgen,
2) daß die Verlustenergie durch Wärmeerzeugung in ohmschen Widerständen vernachlässigbar gering ist, und
3) daß die im piezoelektrischen Element gespeicherte Energie im wesentlichen vollständig in den Kondensator 9 zurückgespeichert wird und somit für eine sofortige Wiederverwendung zur Verfügung steht.

Der erstgenannte Punkt ermöglicht es, die Anzahl der Bauelemente, insbesondere die Anzahl der von Haus aus relativ großen Spulen minimal zu halten. Der zweite und der dritte Punkt ermöglichen es, die Batterie 7 und den Gleichspannungswandler 8 für nur relativ kleine Leistungen auszulegen.

Sämtliche der genannten Punkte - sei es allein oder in Kombination - ermöglichen es oder tragen zumindest dazu bei, die zum Laden und Entladen von piezoelektrischen Elementen vorzusehende Schaltungen auf kleinstem Raum unterzubringen und die Kosten für deren Herstellung und Betrieb minimal zu halten.

Durch das vorstehend dem Wesen nach beschriebene Verfahren zum Laden und Entladen von piezoelektrischen Elementen bzw. durch die zur Durchführung dieses Verfahrens geeignete Schaltung können anstelle von nur einem piezoelektrischen Element aufeinanderfolgen eine Vielzahl von piezoelektrischen Elementen aufeinanderfolgend geladen und entladen werden

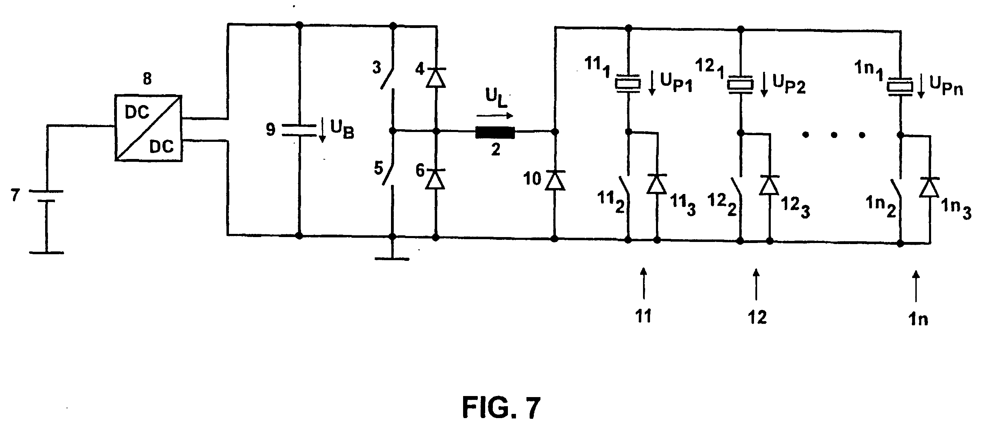

Eine Schaltung, welche dies ermöglicht, ist in Figur 7 dargestellt.

Die in der Figur 7 gezeigte Schaltung basiert auf der in der Figur 1 gezeigten Schaltung; einander entsprechende Elemente sind mit den selben Bezugszeichen bezeichnet. Es ist "nur" das piezoelektrische Element 1 gemäß Figur 1 durch eine Parallelschaltung aus einer weiteren Diode 10 und einer Vielzahl (n) von Piezozweigen 11, 12, ..., 1n ersetzt, wobei jeder Piezozweig aus einer Reihenschaltung aus einem piezoelektrischen Element 11₁, 12₁, ... 1n₁ und einer Parallelschaltung aus einem Auswahlschalter 11₂, 12₂, ... 1n₂ und einer Diode 11₃, 12₃, ..., 1n₃ besteht.

Die Diode 10 verhindert das Auftreten negativer Spannungen an den piezoelektrischen Elementen, da diese hierdurch unter Umständen zerstört werden können.

Die parallel angeordneten Auswahlschalter-Dioden-Paare in den einzelnen Piezozweigen, d.h. der Auswahlschalter 11₂ und die Diode 11₃ im Piezozweig 11, der Auswahlschalter 12₂ und die Diode 12₃ im Piezozweig 12, und der Auswahlschalter 1n₂ und die Diode 1n₃ im Piezozweig 1n können durch elektronische Schalter mit parasitären Dioden wie beispielsweise MOS-FETs realisiert werden.

Das Laden und Entladen der piezoelektrischen Elemente 11₁, 12₁ ... 1n₁ erfolgt dem Wesen nach wie das Laden und Entladen des piezoelektrischen Elements 1 gemäß Figur 1. D.h., zum Laden wird der Ladeschalter 3 wiederholt geschlossen und geöffnet, und zum Entladen wird der Entladeschalter 5 wiederholt geschlossen und geöffnet.

Welches bzw. welche der piezoelektrischen Elemente 11₁, 12₁ ... 1n₁ beim wiederholten Schließen und Öffnen des Ladeschal ters 3 geladen werden, wird durch die Auswahlschalter 11₂, 12₂ ... 1n₂ bestimmt; es werden jeweils all diejenigen piezoelektrischen Elemente 11₁, 12₁ ... 1n₁ geladen, deren Auswahlschalter 11₂, 12₂ ... 1n₂ während des wiederholten Schließens und Öffnens des Ladeschalters 3 geschlossen sind.

Die Auswahl der zu ladenden piezoelektrischen Elemente 11₁, 12₁ ... 1n₁ durch Schließen der zugeordneten Auswahlschalter 11₂, 12₂ ... 1n₂ und das Aufheben der Auswahl durch Öffnen der betreffenden Schalter wird in der Regel außerhalb des Ladevorganges erfolgen; in bestimmten Fällen, z.B. wenn mehrere der piezoelektrischen Elemente 11₁, 12₁ ... 1n₁ gleichzeitig unterschiedlich stark aufgeladen werden sollen, kann das Öffnen und Schließen der Auswahlschalter 11₂, 12₂ ... 1n₂ jedoch auch während des Ladevorganges erfolgen.

Die sich beim Laden der ausgewählten piezoelektrischen Elemente 11₁, 12₁ ... 1n₁ einstellenden Vorgänge sind im wesentlichen identisch mit den sich bei der Schaltung gemäß Figur 1 einstellenden Vorgängen. Es haben auch die Figuren 2 und 3 und die darauf bezugnehmenden Erläuterungen Gültigkeit; einziger Unterschied ist, daß nicht das piezoelektrische Element 1, sondern eines oder mehrere der piezoelektrischen Elemente 11₁, 12₁ ... 1n₁ geladen werden.

Das Entladen der piezoelektrischen Elemente 11₁, 12₁ ... 1n₁ erfolgt unabhängig von der Stellung der zugeordneten Auswahlschalter 11₂, 12₂ ... 1n₂, denn der die Entladung der piezoelektrischen Elemente bewirkende Entladestrom kann über die den jeweiligen piezoelektrischen Elementen zugeordneten Dioden 11₃, 12₃, ... 1n₃ fließen. Durch den Entladevorgang werden daher sämtliche vollständig oder teilweise geladenen piezoelektrischen Elemente 11₁, 12₁ ... 1n₁ entladen.

Die sich beim Entladen der piezoelektrischen Elemente 11₁, 12₁ ... 1n₁ einstellenden Vorgänge sind im wesentlichen identisch mit den sich bei der Schaltung gemäß Figur 1 einstellenden Vorgängen. Es haben auch die Figuren 4 und 5 und die darauf bezugnehmenden Erläuterungen Gültigkeit; einziger Unterschied ist, daß nicht das piezoelektrische Element 1, sondern die piezoelektrischen Elemente 11₁, 12₁ ... 1n₁ entladen werden.

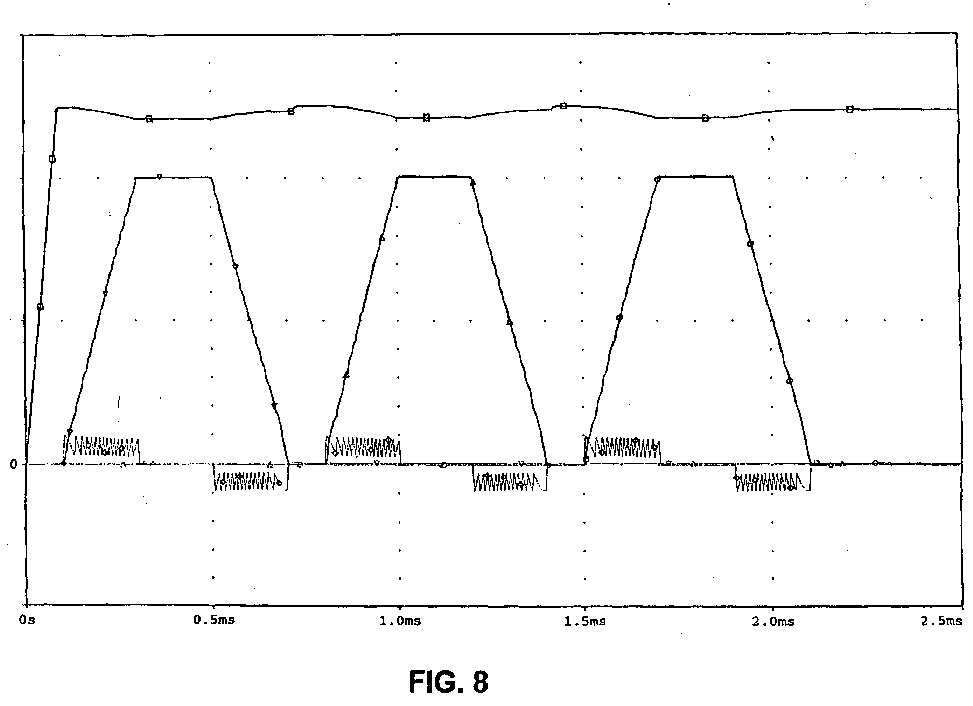

Betreibt man die in der Figur 7 gezeigte Schaltung derart, daß die piezoelektrischen Elemente 11₁, 12₁ ... 1n₁ aufeinanderfolgend einzeln wie vorstehend beschrieben geladen und entladen werden, so stellen sich die in der Figur 8 gezeigten Strom- und Spannungsverläufe ein.

Die in der Figur 8 dargestellten Kurven sind mit deren Meßgrößen repräsentierenden Symbolen versehen. Von den verwendeten Symbolen repräsentieren
- □: die sich am Kondensator 9 einstellende Spannung U_{B},

- ◇: den die Spule 2 durchfließenden Strom
- ∇: die sich am piezoelektrischen Element 11₁ einstellende Spannung,
- Δ: die sich am piezoelektrischen Element 12₁ einstellende Spannung, und
- o: die sich am piezoelektrischen Element 1n₁ einstellende Spannung.

Die in der Figur 8 gezeigten Strom- und Spannungsverläufe veranschaulichen den Lade- und Entladevorgang des piezoelektrischen Elements 11₁ (im Bereich von etwa 0,1 ms bis 0,7 ms auf der Zeitskala), den Lade- und Entladevorgang des piezoelektrischen Elements 12₁ (im Bereich von etwa 0,8 ms bis 1,4 ms auf der Zeitskala), und den Lade- und Entladevorgang des piezoelektrischen Elements 1n₁ (im Bereich von etwa 1,5 ms bis 2,1 ms auf der Zeitskala; sie sind bei der vorstehend vermittelten Kenntnis des Aufbaus, der Funktion und der Wirkungsweise der Schaltung gemäß der Figur 7 ohne weiteres verständlich und bedürfen keiner näheren Erläuterung.

Wie aus der Figur 8 ersichtlich ist, weisen die sich an den piezoelektrischen Elementen einstellenden Spannung einen nahezu linearen und erkennbar gut steuerbaren Verlauf auf.

Gleichzeitig ist die Schaltung, durch die das Laden und Entladen des piezoelektrischen Elements bewirkt wird, genauer gesagt die Schaltung gemäß Figur 7 denkbar einfach aufgebaut und optimal im Wirkungsgrad. Hierzu tragen wie schon im Fall der Schaltung nach der Figur 1 wiederum vor allem bei, daß das Laden und das Entladen über ein und die selbe Spule (nämlich die Spule 2) erfolgen, daß die Verlustenergie durch Wärmeerzeugung in ohmschen Widerständen vernachlässigbar gering ist, und daß die in den piezoelektrischen Element gespeicherte Energie im wesentlichen vollständig in den Kondensator 9 zurückgespeichert wird und somit für eine sofortige Wiederverwendung zur Verfügung steht.

Der erstgenannte Punkt ermöglicht es wiederum, die Anzahl der Bauelemente, insbesondere die Anzahl der von Haus aus relativ großen Spulen minimal zu halten. Der zweite und der dritte Punkt ermöglichen es, die Batterie 7 und den Gleichspannungswandler 8 für nur relativ kleine Leistungen auszulegen.

Sämtliche der genannten Punkte - sei es allein oder in Kombination - ermöglichen es oder tragen zumindest dazu bei, auch die vorliegend betrachtete Schaltung (Schaltung gemäß Figur 7) zum Laden und Entladen von piezoelektrischen Elementen auf kleinstem Raum unterzubringen und die Kosten für deren Herstellung und Betrieb minimal zu halten.

Bei den beschriebenen Ausführungsbeispielen wurde jeweils eine Spule als als Induktanz wirkendes Element verwendet. Hierauf besteht jedoch keine Einschränkung. Anstelle der Spule können (bei entsprechend modifiziertem Schaltungsaufbau und Schaltungsbetrieb) auch andere als Induktanz wirkende Elemente wie Übertrager, Transformatoren etc. verwendet werden.

Es besteht auch keine Einschränkung darauf, das Laden und Entladen wie beschrieben getaktet durchzuführen. Das Laden und/oder das Entladen kann alternativ oder ergänzend auch auf andere Art und Weise durchgeführt werden. Unter anderem könnte vorgesehen werden, das Laden und/oder das Entladen ganz oder teilweise über einen oder mehrere als Schwingkreise wirkende Lade- und Entladestromkreise durchzuführen.

Zusammenfassend kann daher festgestellt werden, daß es die erfindungsgemäße Vorrichtung und das erfindungsgemäße Verfahren es auf einfache und elegante Art und Weise ermöglichen, auch unter beengten Verhältnissen ein effizientes Laden und Entladen piezoelektrischer Elemente durchzuführen.

## Patentansprüche

1. Verfahren zum Laden und Entladen eines piezoelektrischen Elements (1; 11₁, 12₁, ... 1n₁) wobei sowohl das Laden als auch das Entladen über ein als Induktanz wirkende Element (2) erfolgt **dadurch gekennzeichnet dass** der Ladestrom und der Entladestrom über das als Induktanz wirkendes Element geleitet wird, das als Induktanz wirkende Element und das piezoelektrische Element (1; 11₁, 12₁, ... 1n₁) in Reihe geschaltet sind, und das Laden des piezoelektrischen Elements (1; 11₁, 12₁, ... 1n₁) durch wiederholtes Schließen und Öffnen eines Ladeschalters (3) während eines Ladevorgangs erfolgt und/oder dass das Entladen des piezoelektrischen Elements (1; 11₁, 12₁, ... 1n₁) durch wiederholtes Schließen und Öffnen eines Entladeschalters (5) während eines Entladevorgangs erfolgt.

2. Verfahren nach Anspruch 1, **dadurch gekennzeichnet, dass** als Induktanz wirkendes Element (2) eine Spule verwendet wird.

3. Verfahren nach einem der vorhergehenden Ansprüche, **dadurch gekennzeichnet, dass** das Schließen des Ladeschalters eine Speicherung von Energie im als Induktanz wirkenden Element (2) bewirkt, und wobei das Öffnen des Ladeschalters die Abgabe der in dem als Induktanz wirkenden Element gespeicherten Energie an das piezoelektrische Element (1; 11₁, 12₁, ... 1n₁) bewirkt.

4. Verfahren nach einem der vorhergehenden Ansprüche, **dadurch gekennzeichnet, dass** das Schließen des Entladeschalters einen Transfer von im piezoelektrischen Element (1; 11₁, 12₁, ... 1n₁) gespeicherter Energie zum als Induktanz wirkenden Element (2) bewirkt, und wobei das Öffnen des Entladeschalters die Abgabe der in dem als Induktanz wirkenden Element gespeicherten Energie bewirkt.

5. Verfahren nach Anspruch 4, **dadurch gekennzeichnet, dass** die vom als Inkuktanz wirkende Element abgegebene Energie an einen einer Versorgungsspannungsquelle (7, 8) nachgeschalteten Pufferkondensator (9) abgegeben wird.

6. Verfahren nach einem der vorherigen Ansprüche, **dadurch gekennzeichnet, dass** das als Inkuktanz wirkende Element zum Laden und Entladen einer Vielzahl von in parallel schalteten Zweigen vorgesehenen piezoelektrischen Elementen (11₁, 12₁, ... 1n₁) verwendet wird.

7. Verfahren nach Anspruch 6, **dadurch gekennzeichnet, dass** das oder die piezoelektrischen Elemente (11₁, 12₁, ... 1n₁), die während eines jeweiligen Ladevorgangs geladen werden sollen, über zugeordnete Auswahlsachalter (11₂, 12₂, ... 1n2)ausgewählt werden.

8. Verfahren nach einem der vorherigen Ansprüche, **dadurch gekennzeichnet, dass** das oder die piezoelektrischen Elemente (1; 11₁, 12₁, ... 1n₁) vor dem Aufladen auf negative Potentiale geschützt werden.

9. Vorrichtung zum Laden und Entladen eines piezoelektrischen Elements (1; 11₁, 12₁, ... 1n₁) wobei sowohl das Laden als auch das Entladen über dieses als Induktanz wirkende Element (2) erfolgt **dadurch gekennzeichnet, dass**, der Ladestrom und der Entladestrom über das als Induktanz wirkendes Element geleitet wird, das als Induktanz wirkende Element und das piezoelektrische Element (1; 11₁, 12₁, ... 1n₁) in Reihe geschaltet sind, und das Laden des piezoelektrischen Elements (1; 11₁, 12₁, ... 1n₁) durch wiederholtes Schließen und Öffnen eines Ladeschalters (3) während eines Ladevorgangs erfolgt und/oder dass das Entladen des piezoelektrischen Elements (1; 11₁, 12₁, ... 1n₁) durch wiederholtes Schließen und Öffnen eines Entladeschalters (5) während eines Ladevorgangs erfolgt.

## Claims

1. Method for charging and discharging a piezoelectric element (1; 11₁, 12₁, ... 1n₁), both the charging and the discharging being carried out by means of an element (2) which acts as an inductor, **characterized in that** the charge current and the discharge current are conducted via the element which acts as an inductor, the element which acts as an inductor and the piezoelectric element (1; 11₁, 12₁, ... 1n₁) are connected in series, and the charging of the piezoelectric element (1; 11₁, 12₁, ... 1n₁) is carried out by repeatedly closing and opening a charge switch (3) during a charging process, and/or **in that** the discharging of the piezoelectric element (1; 11₁, 12₁, ... 1n₁) is carried out by repeatedly closing and opening a discharge switch (5) during a discharging process.

2. Method according to Claim 1, **characterized in that** a coil is used as an element (2) which acts as an inductor.

3. Method according to one of the preceding claims, **characterized in that** the closing of the charge switch causes energy to be stored in the element (2) which acts as an inductor, the opening of the charge switch causing the energy which is stored in the element which acts as an inductor to be output to the piezoelectric element ((1; 11₁, 12₁, ... 1n₁).

4. Method according to one of the preceding claims, **characterized in that** the closing of the discharge switch causes energy stored in the piezoelectric element (1; 11₁, 12₁, ... 1n₁) to be transferred to the element (2) which acts as an inductor, the opening of the discharge switch causing the energy which is stored in the element which acts as an inductor to be output.

5. Method according to Claim 4, **characterized in that** the energy which is output by the element which acts as an inductor is output to a buffer capacitor (9) which is connected downstream of a supply voltage source (7, 8) .

6. Method according to one of the preceding claims, **characterized in that** the element which acts as an inductor is used to charge and discharge a plurality of piezoelectric elements (11₁, 12₁, ... 1n₁) which are provided in branches which are connected in parallel.

7. Method according to Claim 6, **characterized in that** the piezoelectric element or elements (11₁, 12₁, ... 1n₁) which are to be charged during a respective charging process are selected by means of assigned selection switches (11₂, 12₂, ... 1n₂).

8. Method according to one of the preceding claims, **characterized in that** the piezoelectric element or elements (1; 11₁, 12₁, ... 1n₁) are protected against charging to negative potentials.

9. Device for charging and discharging a piezoelectric element (1; 11₁, 12₁, ... 1n₁), both the charging and the discharging being carried out by means of an element (2) which acts as an inductor, **characterized in that** the charge current and the discharge current are conducted via the element which acts as an inductor, the element which acts as an inductor and the piezoelectric element (1; 11₁, 12₁, ... 1n₁) are connected in series, and the charging of the piezoelectric element (1; 11₁, 12₁, ... 1n₁) is carried out by repeatedly closing and opening a charge switch (3) during a charging process, and/or **in that** the discharging of the piezoelectric element (1; 11₁, 12₁, ... 1n₁) is carried out by repeatedly closing and opening a discharge switch (5) during a discharging process.

## Revendications

1. Procédé pour charger et décharger un élément piezo-électrique (1 ; 11₁, 12₁, ... 1n₁ ), selon lequel aussi bien la charge que la décharge a lieu par l'intermédiaire d'un élément agissant en inductance,
**caractérisé en ce que**
le courant de charge et le courant de décharge passent dans un élément agissant en inductance monté en série avec l'élément piezo-électrique (1 ; 11₁, 12₁, ... 1n₁ ), la charge de l'élément piezo-électrique (1 ; 11₁, 12₁, ... 1n₁ ) s'effectuant par ouverture et fermeture à répétition d'un contacteur de charge (3) pendant une opération de charge, et/ou la décharge de l'élément piezo-électrique (1 ; 11₁, 12₁, ... 1n₁ ) s'effectuant par ouverture et fermeture à répétition d'un contacteur de décharge (5) pendant une opération de décharge.

2. Procédé selon la revendication 1,
**caractérisé en ce qu'**
une bobine est utilisée comme élément (2) agissant en inductance.

3. Procédé selon l'une des revendications précédentes,
**caractérisé en ce que**
la fermeture du contacteur de charge produit une accumulation d'énergie dans l'élément (2) agissant en inductance, tandis que l'ouverture du contacteur de charge fait délivrer à l'élément piezo-électrique (1 ; 11₁, 12₁, ... 1n₁ ) l'énergie accumulée dans l'élément agissant en inductance.

4. Procédé selon une des revendications précédentes,
**caractérisé en ce que**
la fermeture du contacteur de décharge produit un transfert de l'énergie accumulée dans l'élément piezo-électrique (1 ; 11₁, 12₁, ... 1n₁ ) à l'élément agissant en inductance (2), tandis que l'ouverture du contacteur de décharge délivre l'énergie accumulée dans l'élément agissant en inductance.

5. Procédé selon la revendication 4,
**caractérisé en ce que**
l'énergie délivrée par l'élément agissant en inductance est délivrée à un condensateur tampon (9) monté en aval d'une source de tension d'alimentation (7, 8).

6. Procédé selon une des revendications précédentes,
**caractérisé en ce que**
l'élément agissant en inductance est utilisé pour charger et décharger un certain nombre d'éléments piezo-électriques (1 ; 11₁, 12₁, ... 1n₁ ) prévus dans des branches montées en parallèle.

7. Procédé selon la revendication 6,
**caractérisé en ce que**
le ou les éléments piezo-électriques (1 ; 11₁, 12₁, ... 1n₁) qui doivent être chargés pendant chaque opération de charge sont sélectionnés par l'intermédiaire de contacteurs de sélection (11₂, 12₂, ... 1n₂) associés.

8. Procédé selon une des revendications précédentes,
**caractérisé en ce que**
le ou les éléments piezo-électriques (1 ; 11₁, 12₁, ... 1n₁ ) sont protégés avant d'être chargés à des potentiels négatifs.

9. Dispositif pour charger et décharger un élément piezo-électrique (1 ; 11₁, 12₁, ... 1n₁ ), dans lequel aussi bien la charge que la décharge a lieu par l'intermédiaire d'un élément agissant en inductance (2),
**caractérisé en ce que**
le courant de charge et le courant de décharge passent dans un élément agissant en inductance (2) en série avec l'élément piezo-électrique (1 ; 11₁, 12₁, ... 1n₁ ), la charge de l'élément piezo-électrique (1 ; 11₁, 12₁, ... 1n₁ ) s'effectuant par ouverture et fermeture à répétition d'un contacteur de charge (3) pendant une opération de charge, et/ou la décharge de l'élément piezo-électrique (1 ; 11₁, 12₁, ... 1n₁ ) s'effectuant par ouverture et fermeture à répétition d'un contacteur de décharge (5) pendant une opération de décharge.
